# EUROPEAN PATENT SPECIFICATION

(11) **EP 2 856 047 B1**
(45) Date of publication and mention of the grant of the patent: **28.02.2018**
(21) Application number: 13723028.0
(22) Date of filing: 24.04.2013
(51) Int. Cl.: F25D 19/00

(54) **A CLOSED CRYOGEN COOLING SYSTEM AND METHOD FOR COOLING A SUPERCONDUCTING MAGNET**
GESCHLOSSENES KRYOGENES KÜHLSYSTEM UND VERFAHREN ZUR KÜHLUNG EINES SUPRALEITENDEN MAGNETEN
SYSTÈME DE REFROIDISSEMENT CRYOGÉNIQUE FERMÉ ET PROCÉDÉ DE REFROIDISSEMENT D'UN AIMANT SUPRACONDUCTEUR

(30) Priority: 01.06.2012 GB 201209853
(43) Date of publication of application: 08.04.2015
(73) Proprietor: Siemens Healthcare Limited, Frimley, Camberley, Surrey GU16 8QD (GB)
(72) Inventor: MIKHEEV, Vladimir, Bicester Oxfordshire OX26 3TE (GB)
(74) Representative: Maier, Daniel Oliver
(86) International application number: PCT/EP2013/058556
(87) International publication number: WO 2013/178408

(56) References cited:
- EP-A1- 2 090 850
- EP-A2- 2 479 525
- DE-A1-102010 041 194
- DE-A1-102011 003 041
- JP-A- H11 193 979
- LONGSWORTH ET AL: "Interfacing small closed-cycle refrigerators to liquid helium cryostats", CRYOGENICS, ELSEVIER, KIDLINGTON, GB, vol. 24, no. 4, 1 April 1984 (1984-04-01), pages 175-178, XP024048859, ISSN: 0011-2275, DOI: 10.1016/0011-2275(84)90124-3 [retrieved on 1984-04-01]

## Description

Early superconducting magnets for MRI systems were cooled by partial immersion in a bath of liquid cryogen. However, more recent designs have reduced the quantity of liquid cryogen required, typically by using a cooling loop arrangement. Such systems usually have a relatively small cryogen vessel positioned at the top of the cooling loop and below a recondensing refrigerator, to provide liquid cryogen which is fed into thermal contact with the magnet under the influence of gravity. Warmed, or boiled, cryogen returns through the cooling loop to the cryogen vessel for recooling. However, such an arrangement tends to have a height greater than the available height within a typical installation room. The positioning of the recondensing refrigerator at the top of the magnet is inconvenient for servicing and replacement of the recondensing refrigerator.

Some conventional arrangements provide a recondensing refrigerator at a reduced height, thermally linked to a cryogen vessel through a solid thermal bus-bar. However, at the temperature required to re-condense cryogens such as helium, a cooling power of only 1W is common. The solid bus-bar may need to have a length of about 1m and needs to be highly thermally conductive. Such bus-bars are typically made from high purity annealed copper or high purity annealed aluminium with a very large cross-sectional area in order to transfer cooling power from the refrigerator to the cryogen vessel without significant loss. They are very expensive to produce. For example, a conventional 50 cm bus bar may cause a temperature rise of 0.1 K or more. This makes the bus bar arrangement bulky and expensive to manufacture. It has been found difficult to produce perfectly flat contact surfaces for the thermal connection between the bus bar and the refrigerator. This tends to result in only point contacts which can be improved by filling the joint with indium or grease, or mechanically compressing the joints. However, such joints are difficult to make. Replacement of the recondensing refrigerator in the field may mean that the contacts need to be reproduced on site, which is found to be unreliable. Imperfect connections result in lost cooling power and may result in loss of cryogen.
The present invention relates to cooling arrangements for cryogen cooled superconducting magnets such as used in MRI systems. In particular it relates to arrangements for controlling the level of liquid cryogen in a cryogen vessel of compact magnet systems.
The present invention accordingly aims to provide an arrangement in which a cryogen vessel is arranged no higher than the top of a cryostat housing a superconducting magnet, yet which allows cryogen gas to be re-condensed and supplied to the cryogen vessel near the top of the superconducting magnet to be fed to a cooling loop.
Conventional MRI cooling systems have a recondensing refrigerator arranged to liquefy cryogen gas within a cryogen vessel. The liquefied cryogen gas is then fed to a cooling loop under the influence of gravity. In the present invention, the recondensing refrigerator is not placed above the magnet, but is provided in association with a separate recondensing chamber, positioned rather lower than the cryogen vessel connected to the cooling loop.
Such arrangements are particularly useful where MRI systems are to be installed in locations where available height is limited.
Background information on conventional arrangements is provided in US patents US 4,464,904; US 5,335,503; US 5,549,142; US 5,937,655; US 6,996,994 and Japanese patent publications JPH11193979 and JP2004033260 The present invention accordingly provides methods and apparatus as set out in the appended claims.

The above and further objects characteristics and advantages of the present invention will become more apparent from consideration of the following description of certain embodiments given by way of example is only, in conjunction with the following the accompanying drawings, wherein:

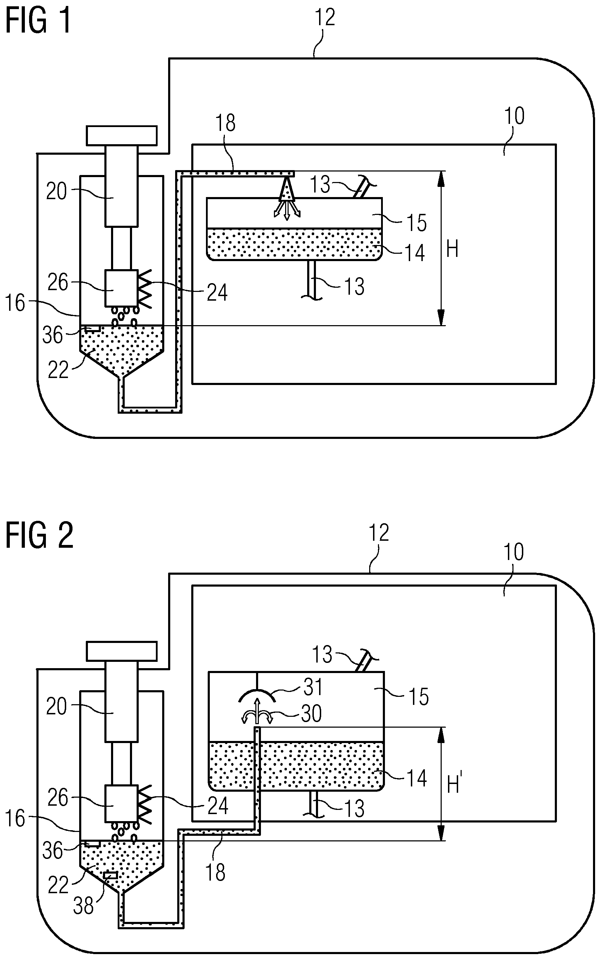

Figures 1 to 4 schematically illustrate example cooling arrangements of the present invention.

The present invention provides a cryogen cooling system comprising two hydraulically connected reservoirs. The system operates a closed cryogenic cycle, including liquefaction and evaporation.

In Fig. 1, a superconducting magnet 10 is housed within an evacuated cryostat 12 and is provided with a cooling loop arrangement 13 which is supplied with by liquid cryogen 14 from a cryogen vessel 15 positioned near the top of the magnet 10. The cryogen may be helium, although other suitable cryogens are known to those skilled in the art. Liquid cryogen 22 is provided from a recondensing chamber 16 through cryogen supply pipe 18 connected at one end near a lower extremity of recondensing chamber 16 and connected at the other end near an upper extremity of cryogen vessel 15. A recondensing refrigerator 20 is arranged to recondense cryogen vapour within the recondensing chamber 16 into liquid cryogen 22, at a temperature of about 4.2 K in the case of helium. According to an aspect of the invention, a lower extremity of the cryogen vessel 15 is above the lower extremity of recondensing chamber 16. As illustrated, liquid cryogen from recondensing chamber 16 must rise a height *H* to reach cryogen vessel 15. Height *H* may typically be between 0.5 to 1.0 m. A heater 24 is positioned within, or at least in thermal contact with, the recondensing chamber 16. In Fig. 1, this heater is shown attached to the recondensing surface 26 of the recondensing refrigerator 20, but may be positioned elsewhere within thermal contact with the recondensing chamber 16. It may be integrated into the recondensing refrigerator 20. It may be placed on an exterior surface of the recondensing chamber 16. The recondensing vessel is thermally insulated by vacuum space from the cryogen vessel 15.

According to an aspect of the invention, liquid helium from recondensing chamber 16 is driven up through pipe 18 to the cryogen vessel 15 by controlled variation in the pressure of cryogen gas within recondensing chamber 16.

An example method of operation of the present invention may proceed as follows. In a steady state, recondensing refrigerator 20 operates at a working temperature of 4.2 K in contact with helium gas at a pressure of 14.5 psi (100kPa) absolute within the recondensing chamber 16. The recondensing refrigerator may have an effective cooling power of 1W at 4.2 K. Helium gas within the cryogen vessel 15 is a standard pressure of 15.3 psi (105.5kPa) absolute. This pressure, being higher than the gas pressure within the recondensing chamber 16, drives helium gas from cryogen vessel 15 into recondensing chamber 16. In the recondensing chamber 16, the helium gas is liquefied and maintains a gas pressure lower than that in the cryogen vessel 15. Accordingly, cryogen gas tends to flow from cryogen vessel 15 to recondensing chamber 16. Once a predetermined quantity of liquid helium has accumulated within the recondensing chamber 16, operation of the recondensing refrigerator 20 may cease, heater 24 is then energised and warms cryogen gas within the recondensing chamber 16. The recondensation stops and the pressure of cryogen gas within the recondensing chamber 16 rises. Once the pressure of cryogen gas within the recondensing chamber 16 rises above the pressure of cryogen gas in cryogen vessel 15 by a sufficient amount, liquid cryogen 22 is forced from the recondensing chamber 16 through pipe 18 into the cryogen vessel 15. Once the level of liquid cryogen within the recondensing chamber 16 reaches a predetermined minimum level, which may be "empty", the heater 24 is de-energised and re-condensation of helium gas will recommence. This operation will continue cyclically to ensure that a supply of liquid cryogen is always provided within cryogen vessel 15, by periodically replenishing the cryogen vessel 15 with liquid cryogen from the re-condensing chamber 16.

In this example, the present invention makes use of the relatively low density of liquid helium and the relatively large coefficient of thermal expansion of gaseous helium. Atmospheric pressure corresponds to approximately 10 m height of water or 80 m height of liquid helium. This means that a relatively low pressure difference is required. Only about 10 mbar or 1% of atmospheric pressure should be sufficient to raise liquid helium over 800mm.

There is only a very small temperature difference between liquid cryogen in the recondensing chamber 16 and liquid cryogen in the cryogen vessel 15, and the thermal conductivity of liquid helium is relatively low, so any heat load on the recondensing vessel due to the pipe 18 is likely to be insignificant.

The upper end of pipe 18 is exposed to cryogen gas in the cryogen vessel 15. The lower end of pipe 18 is exposed to the interior of recondensing chamber 16 towards or at its lower extremity. Once a small quantity of liquid cryogen is recondensed in the recondensing chamber 16, the lower end of pipe 18 will be immersed in liquid cryogen forming a hydraulic lock. The pressure difference in gaseous cryogen between the cryogen vessel 15 and the recondensing chamber 16 will be sufficient to draw gaseous cryogen from cryogen vessel 15 through pipe 18 to recondensing chamber 16 when recondensing refrigerator 20 is in operation. Recondensation of gaseous cryogen in the recondensing chamber 16 will keep the gas pressure within the recondensing chamber 16 lower than gas pressure in cryogen vessel 15.

If the gas pressure within the recondensing chamber 16 is sufficient, and the cooling power of the recondensing refrigerator 20 is known, one can calculate the rate at which cryogen will condense, and cycles of replenishing the cryogen vessel 15 may simply be timed. For instance, cooling helium at 4.2K at a power of 1 W will cause about 1 litre of liquid helium to recondense in one hour. At predetermined time intervals, corresponding to expected quantities of recondensed cryogen, operation of the recondensing refrigerator 20 may cease, and heater 24 may be energised. The resulting heating of gaseous cryogen will cause expansion of the gas and an increase of gas pressure within recondensing chamber 16. Once that gas pressure exceeds the gas pressure within the cryogen vessel 15 sufficiently, liquid cryogen 22 will be driven from recondensation chamber 16 into cryogen vessel 15. The heating may be continued for a fixed period of time, deemed sufficient to drive all, or a predicted quantity, of the liquid cryogen from recondensation chamber 16 to cryogen vessel 15. Alternatively, sensors may be provided to detect a minimum level of liquid cryogen 22 in the recondensing chamber 16, or a maximum level of liquid cryogen in the cryogen vessel 15, and the heater 24 may be de-energised as soon as one of these sensors indicates that one of these conditions has been reached. Similarly, a sensor may be provided to detect a maximum level of liquid cryogen within the recondensing chamber 16, or a minimum level of liquid cryogen within the cryogen vessel 15 and to energise heater 24 once this maximum level is reached.

In the case of helium cryogen, the expansion coefficient at about 4K is so large that only a very small temperature rise, in the order of 10 mK, is expected to be sufficient to create a pressure increase of about 10 mbar and drive liquid helium up a height H of about 800 mm.

If heater 24 remains energised for long enough, all of the liquid cryogen within recondensing chamber 16 will be driven into the cryogen vessel 15. At this point the gas pressures within recondensing chamber 16 and cryogen vessel 15 will equalise. Heater 24 is then de-energised and the sequence repeats.
In alternative arrangements, the refrigerator 20 may remain operational while heater 24 is energised, the cooling power of the refrigerator 20 being easily overcome by the heating effect of a simple electrical heater 24.

The heater may be a simple coil of resistive wire provided with an electrical current by electrical connections integrated into the refrigerator 20. The heater itself may be integrated into the recondensing refrigerator, for example being attached to an outer surface. Alternatively, the heater may be placed on the outer surface of recondensing chamber 16, in thermal contact with it.
The depth of liquid helium within recondensing chamber 16 may be monitored by temperature sensors placed at appropriate locations either within or on the external surface of the recondensing chamber 16. The temperature sensors may be electrical resistors, or any other known level gauges such as those relying upon capacitance, superconduction etc., suitably connected to a control system. The control system may use measurements provided by the sensors to control the operation of the heater 24 and a drive the hydraulic lift of liquid cryogen from recondensing chamber 16 into cryogen vessel 15.
The recondensing chamber 16 need not be located immediately adjacent to the cryogen vessel 15 but may be positioned elsewhere in a room with the MRI system. However, suitable thermal insulation must be provided around the pipe 18 connecting the recondensing chamber 16 with the cryogen vessel 15. Such thermal insulation will typically include vacuum insulation.

Fig. 2 shows an alternative illustrative example. In this embodiment, the pipe 18 enters the cryogen vessel 15 near its lower extremity, and continues upward inside the cryogen vessel 15 to a maximum height H' above a maximum liquid cryogen level in the recondensing chamber 16, which may be significantly less than the corresponding height H of the embodiment of Fig. 1. In this arrangement, liquid cryogen may be raised from recondensing chamber 16 to cryogen vessel 15 by a much smaller differential gas pressure than in the case of the embodiment of Fig. 1. Although not necessary, the illustrated embodiment shows an upwardly-directed upper end of pipe 18, wherefrom liquid cryogen may emerge as a fountain 30. An umbrella 31 may be provided above the upper end of pipe 18. The purpose of such an umbrella is as follows. If the cryogen vessel 15 contains a relatively low level of liquid cryogen, then its upper surface may be relatively warm. The umbrella prevents direct contact between the incoming liquid cryogen, to ensure that the liquid helium is not warmed by the upper surface of the cryogen vessel, leaving the upper surface of the cryogen vessel to be cooled by circulation of the warmer cryogen gas within the cryogen vessel.

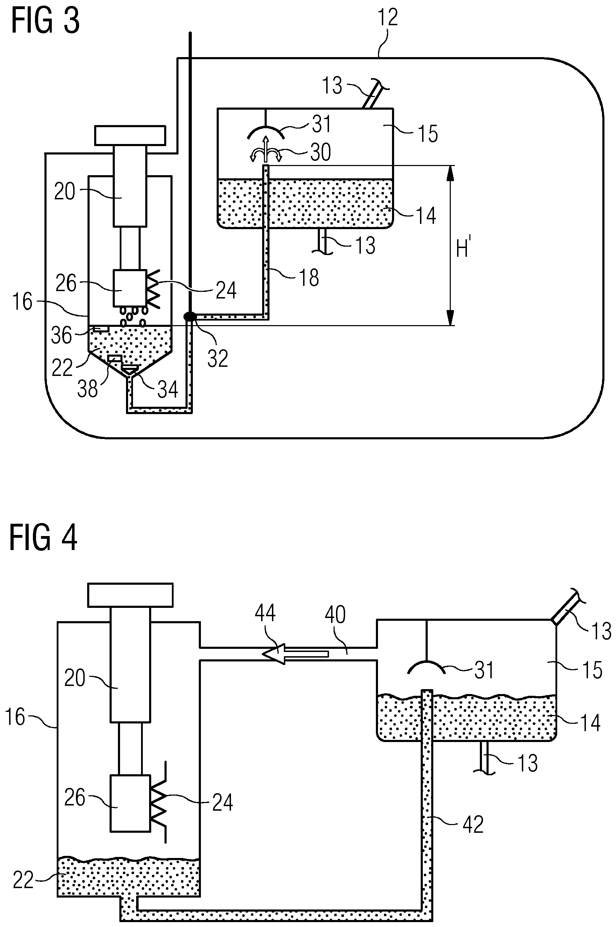

Fig. 3 shows a development of the embodiment of Fig. 2. Here, a valve 32 is provided, to control the flow of liquid cryogen 22 from the recondensing chamber 16 to the cryogen vessel 15, and the flow of cryogen gas from the cryogen vessel 15 to the recondensation chamber 16. The valve 32 may be controlled manually or automatically by a magnet control system or otherwise. If a service operation is required, which necessitates removal of the refrigerator 20, valve 32 should be closed before the refrigerator is removed, to prevent ingress of air into the cryogen vessel 15.

Also shown is an optional further valve 34, which may be also or alternatively be used to prevent ingress of air into the cryogen vessel 15 during servicing operations within the recondensing chamber, such as replacement of recondensing refrigerator 20.

In Figs. 1-3, a maximum liquid cryogen level sensor 36 is shown within the recondensing chamber 16. This sensor is used to detect the filling of the recondensing chamber 16 to a predetermined maximum level and output from this sensor may be provided to a controller and in response, the controller may activate heater 24 to begin driving liquid cryogen 22 from the recondensing chamber 16 into the cryogen vessel 15. Also shown in Figs. 2 and 3 is a minimum liquid cryogen level sensor 38 within the recondensing chamber 26. This sensor is used to indicate that heater 24 should be de-energised to stop the flow of liquid cryogen 22 from recondensing chamber 16 to cryogen vessel 15. In the embodiment of Fig. 1, no minimum liquid cryogen level sensor is provided. Instead, heater 24 may simply be energised for a predetermined period of time sufficient to drive a predicted quantity of liquid cryogen 22 into the cryogen vessel 15. Alternatively, if required, the heater 24 may be energised for a time sufficient to drive all liquid cryogen from recondensing chamber 16 into cryogen vessel 15.

Temperature sensors 36, 38 may alternatively be positioned on an outer surface of the recondensing chamber 16.

It is preferred that the open end of pipe 18 should be quite near the upper surface of the cryogen vessel, such that the warmer cryogen gas nearer the top of the cryogen vessel is taken for recondensation. This is believed to result in improved thermal stability of the cryogen vessel.

The total quantity of cryogen within the recondensing chamber 16 and cryogen vessel 15 is preferably determined such that the upper end of pipe 18 always remains above the liquid level in cryogen vessel 15.

The present invention accordingly provides apparatus and methods for replenishing a cryogen vessel arranged for cooling a superconducting magnet in which a recondensing refrigerator is provided at a height significantly below that of conventional arrangements the inventive arrangement is simple and compact. The cost of manufacture of the arrangement of the present invention is significantly less than that of conventional arrangements. The relative positioning of the recondensing chamber and the cryogen vessel is very flexible and allows easy replacement of the refrigerator when required. The use of the optional valve allows for the warming of the recondensing chamber to room temperature while maintaining cryogenic temperatures within the cryogen vessel.

Fig. 4 shows an alternative arrangement according to the present invention, in which two pipes 40, 42 are provided, linking the recondensing chamber 16 and the cryogen vessel 15. A first pipe 40 links an upper part of the recondensing chamber 16 with an upper part of the cryogen vessel 15, and serves to carry cryogen gas from the cryogen vessel 15 to the recondensing chamber 16. A one-way valve 44 is provided within this tube, to prevent cryogen gas flow in the reverse direction when heater 24 is active. The second pipe 42 joins lower parts of the recondensing chamber 16 and the cryogen vessel 15, and provides a passage for the flow of liquid cryogen from the recondensing chamber to the cryogen vessel 15.

## Claims

1. A cryogen cooling system for cooling a superconducting magnet, comprising:
a cryogen vessel (14) linked to a cooling loop arrangement (13) in thermal contact with a superconducting magnet;
a recondensing refrigerator (20) arranged to recondense cryogen gas within the recondensing chamber (16); and
a heater (24) positioned to heat gaseous cryogen within a recondensing chamber (16); **characterised in that** a recondensation chamber (16) is arranged such that a lower extremity of the cryogen vessel (15) is above a lower extremity of the recondensing chamber (16); **in that** the recondensing chamber (16) is hydraulically connected to the cryogen vessel (14) by a first pipe (40) which links an upper part of the recondensing chamber (16) with an upper part of the cryogen vessel (15) to provide a passage for the flow of cryogen gas from the cryogen vessel to the recondensing chamber through a one-way valve (44); and **in that** a second pipe (42) which links lower parts of the recondensing chamber (16) and the cryogen vessel (15), to provide a passage for the flow of liquid cryogen from the recondensing chamber to the cryogen vessel.

2. A cryogen cooling system according to claim 1, further comprising a sensor (38) for detecting a minimum level of liquid cryogen (22) in the recondensing chamber (16).

3. A cryogen cooling system according to any preceding claim, further comprising a sensor (36) for detecting a maximum level of liquid cryogen (22) in the recondensing chamber (16).

4. A cryogen cooling system according to any preceding claim, further comprising a sensor (36) for detecting a maximum level of liquid cryogen (14) in the cryogen vessel (15).

5. A cryogen cooling system according to any of claims 2-4, further comprising a controller arranged to energise and de-energise the heater (24) in response to signals provided by the sensor, or one of the sensors.

6. A cryogen cooling system according to any preceding claim, further comprising a valve (32) provided to control flow through cryogen supply pipe (18).

7. A cryogen cooling system according to any preceding claim, further comprising a removable plug (34) for closing the lower end of the cryogen supply pipe (18).

8. A cryogen cooling system according to any preceding claim, wherein the heater (24) is integrated into the recondensing refrigerator (20).

9. A cryogen cooling system according to any preceding claim, wherein the heater (24) is attached to an outer surface of the recondensing chamber (16), in thermal contact with the recondensing chamber (16).

10. A cryogen cooling system according to claim 1, wherein the upper end of the cryogen supply pipe (18) is located at or near an upper extremity of the cryogen vessel.

11. A cryogen cooling system according to claim 10 wherein an umbrella (31) is provided above the upper end of cryogen supply pipe (18).

12. A method for replenishing the cryogen vessel (14) of the cryogen cooling system according to any preceding claim with liquid cryogen, comprising the steps of:
a) providing cryogen in a closed volume comprising the recondensing chamber (16), the cryogen supply pipe (18), the cryogen vessel (14) and the cooling loop;
b) operating the recondensing refrigerator (20) to liquefy cryogen gas within the recondensing chamber (16), thereby reducing a gas pressure within the recondensing chamber (16) to below a gas pressure within the cryogen vessel;
c) supplying cryogen gas from the cryogen vessel (15) through the cryogen supply pipe (18) to the recondensing chamber (16);
d) continuing to liquefy cryogen gas within the recondensing chamber (16) to provide a volume of liquid cryogen (22) within the recondensing chamber (16);
e) energising the heater (24) to heat cryogen gas within the cryogen vessel, thereby to increase a gas pressure within the recondensing chamber (16) above a gas pressure within the cryogen vessel;
f) driving at least part of the volume of liquid cryogen (22) from the recondensing chamber (16) through the cryogen supply pipe to the cryogen vessel by the difference in gas pressures in the recondensing chamber (16) and the cryogen vessel; and
g) de-energising the heater.

13. A method according to claim 12, further comprising
cyclically repeating steps (b) - (g).

14. A method according to claim 13, wherein step (e) commences at predetermined time intervals corresponding to the expected accumulation of quantities of liquid cryogen (22) within the recondensing chamber (16).

15. A method according to any of claims 12-13 wherein step (e) commences in response to an output of a sensor (36) indicating that a maximum level of liquid cryogen (22) is present in the recondensing chamber (16).

16. A method according to any of claims 12, 13 or 15 wherein step (g) commences in response to an output of a sensor (38) indicating that a minimum level of liquid cryogen (22) is present in the recondensing chamber (16).

17. A method according to any of claims 12-16 wherein step (e) commences in response to an output of a sensor indicating that a minimum level of liquid cryogen (22) is present in the cryogen vessel.

18. A method according to any of claims 12-17 wherein step (g) commences in response to an output of a sensor indicating that a maximum level of liquid cryogen (22) is present in the cryogen vessel.

19. A method according to any of claims 12-13 wherein steps (e) and (f) continue for fixed periods of time.

20. A method according to any of claims 12-19 wherein operation of the recondensing refrigerator (20) is suspended during steps (e) and (f).

## Patentansprüche

1. Kryogenkühlsystem zum Kühlen eines supraleitenden Magneten, welches umfasst:
ein Kryogengefäß (14), das mit einer Kühlkreislaufanordnung (13) gekoppelt ist, die sich in thermischem Kontakt mit einem supraleitenden Magneten befindet;
einen Rekondensationskühler (20), der dafür eingerichtet ist, Kryogengas innerhalb der Rekondensationskammer (16) zu rekondensieren; und
einen Heizer (24), der dafür positioniert ist, das gasförmige Kryogen innerhalb einer Rekondensationskammer (16) zu erwärmen;
**dadurch gekennzeichnet, dass** eine Rekondensationskammer (16) derart angeordnet ist, dass sich ein unteres Ende des Kryogengefäßes (15) oberhalb eines unteren Endes der Rekondensationskammer (16) befindet; dadurch, dass die Rekondensationskammer (16) mit dem Kryogengefäß (14) durch ein erstes Rohr (40) hydraulisch verbunden ist, welches einen oberen Teil der Rekondensationskammer (16) mit einem oberen Teil des Kryogengefäßes (15) koppelt, um einen Durchlass für den Durchfluss von Kryogengas aus dem Kryogengefäß zur Rekondensationskammer über ein Einwegventil (44) bereitzustellen; und dadurch, dass ein zweites Rohr (42) untere Teile der Rekondensationskammer (16) und des Kryogengefäßes (15) koppelt, um einen Durchlass für den Durchfluss von flüssigem Kryogen aus der Rekondensationskammer zum Kryogengefäß bereitzustellen.

2. Kryogenkühlsystem nach Anspruch 1, welches ferner einen Sensor (38) zum Detektieren eines minimalen Füllstands von flüssigem Kryogen (22) in der Rekondensationskammer (16) umfasst.

3. Kryogenkühlsystem nach einem der vorhergehenden Ansprüche, welches ferner einen Sensor (36) zum Detektieren eines maximalen Füllstands von flüssigem Kryogen (22) in der Rekondensationskammer (16) umfasst.

4. Kryogenkühlsystem nach einem der vorhergehenden Ansprüche, welches ferner einen Sensor (36) zum Detektieren eines maximalen Füllstands von flüssigem Kryogen (14) in dem Kryogengefäß (15) umfasst.

5. Kryogenkühlsystem nach einem der Ansprüche 2 bis 4, welches ferner eine Steuereinrichtung umfasst, die dafür eingerichtet ist, den Heizer (24) in Reaktion auf Signale, die von dem Sensor oder einem der Sensoren zugeführt werden, einzuschalten oder auszuschalten.

6. Kryogenkühlsystem nach einem der vorhergehenden Ansprüche, welches ferner ein Ventil (32) umfasst, das dafür vorgesehen ist, den Durchfluss durch ein Kryogenzuführrohr (18) zu steuern.

7. Kryogenkühlsystem nach einem der vorhergehenden Ansprüche, welches ferner einen entfernbaren Stopfen (34) zum Verschließen des unteren Endes des Kryogenzuführrohres (18) umfasst.

8. Kryogenkühlsystem nach einem der vorhergehenden Ansprüche, wobei der Heizer (24) in den Rekondensationskühler (20) integriert ist.

9. Kryogenkühlsystem nach einem der vorhergehenden Ansprüche, wobei der Heizer (24) an einer Außenfläche der Rekondensationskammer (16) angebracht ist, in thermischem Kontakt mit der Rekondensationskammer (16).

10. Kryogenkühlsystem nach Anspruch 1, wobei sich das obere Ende des Kryogenzuführrohres (18) an oder in der Nähe eines oberen Endes des Kryogengefäßes befindet.

11. Kryogenkühlsystem nach Anspruch 10, wobei ein Schirm (31) oberhalb des oberen Endes des Kryogenzuführrohres (18) vorgesehen ist.

12. Verfahren zum Wiederauffüllen des Kryogengefäßes (14) des Kryogenkühlsystems nach einem der vorhergehenden Ansprüche mit flüssigem Kryogen, welches die folgenden Schritte umfasst:
a) Bereitstellen von Kryogen in einem geschlossenen Volumen, welches die Rekondensationskammer (16), das Kryogenzuführrohr (18), das Kryogengefäß (14) und den Kühlkreislauf umfasst;
b) Betreiben des Rekondensationskühlers (20), um Kryogengas innerhalb der Rekondensationskammer (16) zu verflüssigen, wodurch ein Gasdruck innerhalb der Rekondensationskammer (16) so verringert wird, dass er niedriger als ein Gasdruck innerhalb des Kryogengefäßes ist;
c) Zuführen von Kryogengas aus dem Kryogengefäß (15) durch das Kryogenzuführrohr (18) zu der Rekondensationskammer (16);
d) Fortsetzen des Verflüssigens von Kryogengas innerhalb der Rekondensationskammer (16), um ein Volumen von flüssigem Kryogen (22) innerhalb der Rekondensationskammer (16) bereitzustellen;
e) Einschalten des Heizers (24), um Kryogengas innerhalb des Kryogengefäßes zu erwärmen, um dadurch einen Gasdruck innerhalb der Rekondensationskammer (16) so zu erhöhen, dass er höher als ein Gasdruck innerhalb des Kryogengefäßes ist;
f) Treiben wenigstens eines Teils des Volumens von flüssigem Kryogen (22) aus der Rekondensationskammer (16) durch das Kryogenzuführrohr in das Kryogengefäß durch die Differenz der Gasdrücke in der Rekondensationskammer (16) und dem Kryogengefäß; und
g) Ausschalten des Heizers.

13. Verfahren nach Anspruch 12, welches ferner umfasst:
zyklisches Wiederholen der Schritte (b) bis (g).

14. Verfahren nach Anspruch 13, wobei Schritt (e) in vorbestimmten Zeitintervallen beginnt, welche der erwarteten Ansammlung von Mengen von flüssigem Kryogen (22) innerhalb der Rekondensationskammer (16) entsprechen.

15. Verfahren nach einem der Ansprüche 12 bis 13, wobei Schritt (e) in Reaktion auf einen Ausgang eines Sensors (36) beginnt, welcher anzeigt, dass ein maximaler Füllstand von flüssigem Kryogen (22) in der Rekondensationskammer (16) vorhanden ist.

16. Verfahren nach einem der Ansprüche 12, 13 oder 15, wobei Schritt (g) in Reaktion auf einen Ausgang eines Sensors (38) beginnt, welcher anzeigt, dass ein minimaler Füllstand von flüssigem Kryogen (22) in der Rekondensationskammer (16) vorhanden ist.

17. Verfahren nach einem der Ansprüche 12 bis 16, wobei Schritt (e) in Reaktion auf einen Ausgang eines Sensors beginnt, welcher anzeigt, dass ein minimaler Füllstand von flüssigem Kryogen (22) in dem Kryogengefäß vorhanden ist.

18. Verfahren nach einem der Ansprüche 12 bis 17, wobei Schritt (g) in Reaktion auf einen Ausgang eines Sensors beginnt, welcher anzeigt, dass ein maximaler Füllstand von flüssigem Kryogen (22) in dem Kryogengefäß vorhanden ist.

19. Verfahren nach einem der Ansprüche 12 bis 13, wobei die Schritte (e) und (f) für feste Zeitabschnitte fortgesetzt werden.

20. Verfahren nach einem der Ansprüche 12 bis 19, wobei der Betrieb des Rekondensationskühlers (20) während der Schritte (e) und (f) ausgesetzt wird.

## Revendications

1. Système de refroidissement à cryogène permettant de refroidir un aimant supraconducteur, comprenant :
une cuve (14) de cryogène reliée à un agencement formant boucle de refroidissement (13) en contact thermique avec un aimant supraconducteur ;
un réfrigérateur recondenseur (20) agencé en vue de recondenser le cryogène gazeux à l'intérieur de la chambre de recondensation (16), et
un dispositif chauffant (24) positionné en vue de réchauffer le cryogène gazeux à l'intérieur d'une chambre de recondensation (16),
**caractérisé en ce qu'**une chambre de recondensation (16) est agencée de telle sorte qu'une extrémité inférieure de la cuve (15) de cryogène soit au-dessus d'une extrémité inférieure de la chambre de recondensation (16) ;
**en ce que** la chambre de recondensation (16) est reliée hydrauliquement à la cuve (14) de cryogène par un premier tuyau (40) qui relie une partie supérieure de la chambre de recondensation (16) à une partie supérieure de la cuve (15) de cryogène pour fournir au flux de cryogène gazeux un passage allant de la cuve de cryogène à la chambre de recondensation via une vanne à une voie (44), et
**en ce qu'**un second tuyau (42) relie des parties inférieures de la chambre de recondensation (16) et de la cuve (15) de cryogène pour fournir au flux de cryogène liquide un passage allant de la chambre de recondensation à la cuve de cryogène.

2. Système de refroidissement à cryogène selon la revendication 1, comprenant par ailleurs un capteur (38) servant à détecter un niveau minimal de cryogène liquide (22) dans la chambre de recondensation (16).

3. Système de refroidissement à cryogène selon l'une quelconque des revendications précédentes, comprenant par ailleurs un capteur (36) servant à détecter un niveau maximal de cryogène liquide (22) dans la chambre de recondensation (16) .

4. Système de refroidissement à cryogène selon l'une quelconque des revendications précédentes, comprenant par ailleurs un capteur (36) servant à détecter un niveau maximal de cryogène liquide (14) dans la cuve (15) de cryogène.

5. Système de refroidissement à cryogène selon l'une quelconque des revendications 2-4, comprenant par ailleurs un dispositif régulateur agencé en vue d'allumer et d'éteindre le dispositif chauffant (24) en réaction à des signaux fournis par le capteur ou l'un des capteurs.

6. Système de refroidissement à cryogène selon l'une quelconque des revendications précédentes, comprenant par ailleurs une vanne (32) prévue pour réguler le flux circulant dans le tuyau (18) d'amenée de cryogène.

7. Système de refroidissement à cryogène selon l'une quelconque des revendications précédentes, comprenant par ailleurs une bonde amovible (34) servant à obturer l'extrémité inférieure du tuyau (18) d'amenée de cryogène.

8. Système de refroidissement à cryogène selon l'une quelconque des revendications précédentes, dans lequel le dispositif chauffant (24) est intégré au réfrigérateur recondenseur (20).

9. Système de refroidissement à cryogène selon l'une quelconque des revendications précédentes, dans lequel le dispositif chauffant (24) est attaché à une surface externe de la chambre de recondensation (16), en contact thermique avec la chambre de recondensation (16).

10. Système de refroidissement à cryogène selon la revendication 1, dans lequel l'extrémité supérieure du tuyau (18) d'amenée de cryogène est située au niveau ou près d'une extrémité supérieure de la cuve de cryogène.

11. Système de refroidissement à cryogène selon la revendication 10, dans lequel une cloche (31) est prévue au-dessus de l'extrémité supérieure du tuyau (18) d'amenée de cryogène.

12. Procédé de remplissage de la cuve (14) de cryogène du système de refroidissement à cryogène selon l'une quelconque des revendications précédentes avec du cryogène liquide, comprenant les étapes consistant :
a) à amener du cryogène dans un volume fermé comprenant la chambre de recondensation (16), le tuyau (18) d'amenée de cryogène, la cuve (14) de cryogène et la boucle de refroidissement ;
b) à faire fonctionner le réfrigérateur recondenseur (20) en vue de liquéfier le cryogène gazeux à l'intérieur de la chambre de recondensation (16), ce qui abaisse une pression de gaz à l'intérieur de la chambre de recondensation (16) en dessous d'une pression de gaz dans la cuve de cryogène ;
c) à amener du cryogène gazeux de la cuve (15) de cryogène jusqu'à la chambre de recondensation (16) via le tuyau (18) d'amenée de cryogène ;
d) à continuer à liquéfier le cryogène gazeux à l'intérieur de la chambre de recondensation (16) pour fournir un certain volume de cryogène liquide (22) à l'intérieur de la chambre de recondensation (16) ;
e) à allumer le dispositif chauffant (24) pour chauffer le cryogène gazeux à l'intérieur de la cuve de cryogène, ce qui fait monter une pression de gaz dans la chambre de recondensation (16) au-dessus d'une pression de gaz à l'intérieur de la cuve de cryogène ;
f) à chasser au moins une partie du volume de cryogène liquide (22) de la chambre de recondensation (16) jusque dans la cuve de cryogène via le tuyau d'amenée de cryogène au moyen de la différence entre les pressions de gaz dans la chambre de recondensation (16) et dans la cuve de cryogène, et
g) à éteindre le dispositif chauffant.

13. Procédé selon la revendication 12, consistant par ailleurs :
à répéter par cycles les étapes (b)-(g).

14. Procédé selon la revendication 13, dans lequel l'étape (e) débute à des intervalles de temps prédéterminés correspondant à l'accumulation attendue de certaines quantités de cryogène liquide (22) à l'intérieur de la chambre de recondensation (16).

15. Procédé selon l'une quelconque des revendications 12-13, dans lequel l'étape (e) débute en réaction à une sortie d'un capteur (36) indiquant qu'un niveau maximum de cryogène liquide (22) est présent dans la chambre de recondensation (16) .

16. Procédé selon l'une quelconque des revendications 12, 13 ou 15, dans lequel l'étape (g) débute en réaction à une sortie d'un capteur (38) indiquant qu'un niveau minimum de cryogène liquide (22) est présent dans la chambre de recondensation (16) .

17. Procédé selon l'une quelconque des revendications 12-16, dans lequel l'étape (e) débute en réaction à une sortie d'un capteur indiquant qu'un niveau minimum de cryogène liquide (22) est présent dans la cuve de cryogène.

18. Procédé selon l'une quelconque des revendications 12-17, dans lequel l'étape (g) débute en réaction à une sortie d'un capteur indiquant qu'un niveau maximum de cryogène liquide (22) est présent dans la cuve de cryogène.

19. Procédé selon l'une quelconque des revendications 12-13, dans lequel les étapes (e) et (f) se poursuivent pendant des périodes de temps fixes.

20. Procédé selon l'une quelconque des revendications 12-19, dans lequel le fonctionnement du réfrigérateur recondenseur (20) est suspendu pendant les étapes (e) et (f).
